# EUROPEAN PATENT APPLICATION

(11) **EP 4 773 732 A1**
(43) Date of publication of application: **08.07.2026**
(21) Application number: 24860246.8
(22) Date of filing: 08.08.2024
(51) Int. Cl.: H05B 6/12, H05B 6/06, H01R 12/71

(54) **INDUCTION HEATING DEVICE HAVING PLURALITY OF BOARDS CONNECTED BY CONNECTORS**

(30) Priority: 30.08.2023 KR 20230114669; 06.03.2024 KR 20240032251
(71) Applicant: Samsung Electronics Co., Ltd., Suwon-si, Gyeonggi-do 16677 (KR)
(72) Inventor: WOO, Younghoon, Suwon-si, Gyeonggi-do 16677 (KR); KIM, Kyounghwan, Suwon-si, Gyeonggi-do 16677 (KR); JUNG, Kyunghoon, Suwon-si, Gyeonggi-do 16677 (KR); HA, Jonghun, Suwon-si, Gyeonggi-do 16677 (KR)
(74) Representative: Gulde & Partner
(86) International application number: PCT/KR2024/011781
(87) International publication number: WO 2025/048325

(57) **Abstract**

Disclosed is an induction heating device comprising a heating coil board on which a plurality of heating coil pattern layers having heating coils printed and patterned thereon are stacked. The induction heating device comprises: an intermediate board including a resonance capacitor, which resonates with a heating coil; and an inverter board, which includes a switching inverter for generating resonance, wherein the intermediate board includes a first connector, the inverter board includes a second connector, and the intermediate board and the inverter board are electrically connected on the basis of the first connector being vertically connected to the second connector.

## Description

### Technical Field

An embodiment of the present disclosure relates to an induction heating device including a plurality of boards that are connected to each other by connectors.

### Background Art

Various types of cooking heating appliances that employ different methods are used to heat food at home or in restaurants. Although gas ranges using gas as fuel were conventionally widespread, cooking heating appliances that heat an object to be heated, such as a cooking vessel like a pot, by using electricity instead of gas have recently become prevalent.

Methods of heating an object to be heated by using electricity are broadly classified into resistance heating methods and induction heating methods. The resistance heating methods involve heating an object to be heated (e.g., a cooking vessel) by transferring heat generated by passing a current through a non-metallic heating element, such as a metal resistance wire or silicon carbide, to the object via radiation or conduction. The induction heating methods involve heating an object to be heated, which is made of a metallic component, by generating an eddy current within the object itself by using a magnetic field that is generated around a coil when high-frequency power of a certain magnitude is applied to the coil. Among these methods, an induction range employing the induction heating method typically includes working coils (heating coils) in corresponding areas to heat a plurality of objects to be heated (cooking vessels), respectively.

Induction ranges are cooking appliances that use the principle of induction heating, and are often referred to as induction cooking ranges, induction heating devices, or induction cooking devices. Compared to gas ranges, induction ranges consume no oxygen and emit no waste gas, and thus may reduce indoor air pollution and a rise in indoor temperature. Furthermore, the demand for induction ranges has been increasing recently due to their advantages in that they employ an indirect method that induces heat in an object to be heated itself, offering high energy efficiency and stability, and the risk of burns is low because heat is generated from the object to be heated itself while the contact surface is not heated.

Recently, a type of induction range (hereinafter referred to as "Anyplace") has been developed that allows an object to be heated to be freely placed anywhere on a top plate. In this type of induction range, an object to be heated may be inductively heated within an area where the plurality of heating coils are present, regardless of the size and position of the object to be heated.

An induction range may include a plurality of boards. When the plurality of boards are connected to each other by wires, the assembly efficiency decreases, which in turn leads to reduced productivity, increased manufacturing costs, and reduced durability. Therefore, a structure is needed that improves assembly efficiency when connecting a plurality of boards.

### Disclosure of Invention

### Solution to Problem

According to an embodiment of the present disclosure, disclosed is an induction heating device including a heating coil board formed by stacking a plurality of heating coil pattern layers on which heating coils are printed and patterned. According to an embodiment, the induction heating device may include an intermediate board arranged under the heating coil board and including resonant capacitors that resonate with the heating coils such that a magnetic field is generated in the heating coils. According to an embodiment, the induction heating device may include an inverter board that includes a switching inverter for generating resonance. According to an embodiment, the intermediate board may further include a first connector, and the inverter board may further include a second connector. According to an embodiment, an electrical connection between the intermediate board and the inverter board may be established based on the first connector and the second connector being connected to each other in a vertical direction.

According to an embodiment of the present disclosure, disclosed is an induction heating device including a heating coil board formed by stacking a plurality of heating coil pattern layers on which heating coils are printed and patterned. According to an embodiment, the heating coil board may further include at least one heating coil board connector. According to an embodiment, the induction heating device may include resonant capacitors that resonate with the heating coils, and at least one first inverter board connector that is connected to the at least one heating coil board connector in a vertical direction. According to an embodiment, the induction heating device may include an inverter board that includes an inverter for generating resonance between the heating coils and the resonant capacitors. According to an embodiment, an electrical connection between the heating coil board and the inverter board may be established solely by connection between the at least one heating coil board connector and the at least one first inverter board connector.

### Brief Description of Drawings

FIG. 1A is a diagram for describing an induction heating device according to an embodiment of the present disclosure.
FIG. 1B is a diagram for describing an induction heating device according to an embodiment of the present disclosure.
FIG. 2 is a cross-sectional view illustrating a state in which a cooking vessel is placed on an induction heating device, according to an embodiment of the present disclosure.
FIG. 3 is an inverter circuit diagram of an induction heating device for operating a plurality of heating coils, according to an embodiment of the present disclosure.
FIG. 4 illustrates an induction heating device using a quadrangular heating coil, according to an embodiment of the present disclosure.
FIG. 5 is a diagram illustrating an induction heating device together with heating coils, according to an embodiment of the present disclosure.
FIG. 6 is a diagram illustrating a structure in which heating coils are connected to an inverter board.
FIG. 7 is another diagram illustrating a structure in which heating coils are connected to an inverter board.
FIG. 8 illustrates a heating coil board of an induction heating device according to an embodiment of the present disclosure.
FIG. 9 is a plan view of a heating coil board according to an embodiment of the present disclosure.
FIG. 10 illustrates a pattern layer including vessel detection coils, according to an embodiment of the present disclosure.
FIG. 11 illustrates a structure in which boards of an induction heating device are connected to each other, according to an embodiment of the present disclosure.
FIG. 12A is a diagram illustrating a structure in which connectors are fastened in an induction heating device.
FIG. 12B is a diagram illustrating a structure in which connectors are fastened in an induction heating device, according to an embodiment of the present disclosure.
FIG. 13A is a diagram illustrating a structure in which connectors are connected to a heating coil board in an induction heating device, according to an embodiment of the present disclosure.
FIG. 13B is a diagram illustrating a structure in which connectors are mounted on the rear surface of a heating coil board in an induction heating device, according to an embodiment of the present disclosure.
FIG. 14 is a diagram illustrating a structure in which connectors are connected to an intermediate board in an induction heating device, according to an embodiment of the present disclosure.
FIG. 15 is a diagram illustrating a structure in which a connector is connected to an inverter board in an induction heating device, according to an embodiment of the present disclosure.
FIG. 16 is a diagram illustrating a structure in which boards are connected to each other by connectors in an induction heating device, according to an embodiment of the present disclosure.
FIG. 17 is a diagram illustrating a structure in which a heating coil board and an intermediate board are connected to each other in an induction heating device, according to an embodiment of the present disclosure.
FIG. 18 is a block diagram of an induction heating device according to an embodiment of the present disclosure.
FIG. 19 is a block diagram of an induction heating device according to an embodiment of the present disclosure.

### Mode for the Invention

Terms used herein will be briefly described, and then an embodiment of the present disclosure will be described in detail.

Although the terms used herein are selected from among common terms that are currently widely used in consideration of their functions in an embodiment of the present disclosure, the terms may be different according to an intention of one of ordinary skill in the art, a precedent, or the advent of new technology. Also, in particular cases, the terms are discretionally selected by the applicant of the present disclosure, in which case, the meaning of those terms will be described in detail in the corresponding description of an embodiment of the present disclosure. Therefore, the terms used herein are not merely designations of the terms, but the terms are defined based on the meaning of the terms and content throughout the present disclosure.

As used herein, the expression "at least one of a, b, or c" may refer to "a", "b", "c", "a and b", "a and c", "b and c", "a, b, and c", or variations thereof.

Throughout the present disclosure, when a part "includes" an element, it is to be understood that the part may additionally include other elements rather than excluding other elements as long as there is no particular opposing recitation. In addition, as used herein, the terms such as "...er (or)", "... unit", "... module", etc., denote a unit that performs at least one function or operation, which may be implemented as hardware or software or a combination thereof.

Hereinafter, embodiments of the present disclosure will be described in detail with reference to the accompanying drawings to allow those of skill in the art to easily carry out the embodiments. An embodiment of the present disclosure may, however, be embodied in many different forms and should not be construed as being limited to the embodiment set forth herein. Furthermore, in the drawings, portions that are irrelevant to the description are omitted to clearly describe an embodiment of the present disclosure, and like reference numerals are assigned to like elements throughout the present disclosure.

An induction heating apparatus may include a plurality of boards, and various methods may be used to electrically connect the plurality of boards to each other. Connecting the plurality of boards to each other via wires may lower assembly efficiency. Lowered assembly efficiency leads to reduced productivity and increased manufacturing costs, and eventually, it also degrades the durability of the induction heating device. Therefore, a structure in which a plurality of boards are connected to each other via connectors may be introduced to improve assembly efficiency, which may in turn increase productivity, lower manufacturing costs, and enhance durability.

Accordingly, an embodiment of the present disclosure provides a structure in which a plurality of boards included in an induction heating device are coupled to each other via vertical connectors.

In the present disclosure, a board may include a printed circuit board (PCB) on which a patterned circuit is printed. When a plurality of boards is stacked, insulating layers may be included between them.

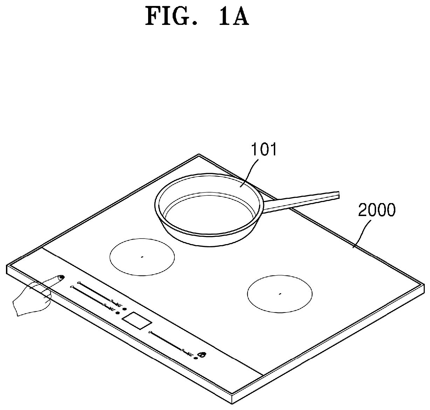

FIG. 1A is a diagram for describing an induction heating device according to an embodiment of the present disclosure.

Referring to FIG. 1A, an induction heating device 2000 according to an embodiment of the present disclosure may include a plurality of heating zones 201, 202, and 203. Hereinafter, the induction heating device 2000 may be referred to as an induction heating device, an induction cooking device, or simply a heating device. Not all of the components illustrated in FIG. 1A are essential components. The induction heating device 2000 may be implemented with more or fewer components than the illustrated components.

A cooking vessel 101 may be a device for heating the contents therein. The contents in the cooking vessel 101 may be liquids, such as water, tea, coffee, soup, juice, wine, or oil, or solids, such as butter, meat, vegetables, bread, or rice, but are not limited thereto.

According to an embodiment of the present disclosure, the cooking vessel 101 may wirelessly receive power from the induction heating device 2000 by using electromagnetic induction. Thus, the cooking vessel 101 according to an embodiment of the present disclosure may not include a power cord for connection to a power outlet.

According to an embodiment of the present disclosure, there may be various types of cooking vessels 101 that wirelessly receive power from the induction heating device 2000. The cooking vessel 101 may be a general induction heating (IH) vessel (hereinafter, referred to as an IH vessel) that includes a magnetic material. A magnetic field may be induced in the cooking vessel 101 itself, which includes a magnetic material.

The cooking vessel 101 may be a general IH vessel such as a pot, a frying pan, or a steamer. The cooking vessel 101 may include a cooker appliance. The cooker appliance may be an appliance into which a general IH vessel may be removably inserted. According to an embodiment, the cooker appliance may be an appliance capable of automatically cooking contents according to a recipe. The cooker appliance may be referred to as a pot, a rice cooker, or a steamer, depending on its intended use. For example, in a case in which an inner pot for cooking rice is inserted into the cooker appliance, the cooker appliance may be referred to as a rice cooker. Hereinafter, the cooker appliance may be defined as a smart pot.

According to an embodiment of the present disclosure, in a case in which the cooking vessel 101 includes a communication interface, the cooking vessel 101 may communicate with the induction heating device 2000. The communication interface may include a short-range wireless communication interface, a long-range communication interface, or the like. The short-range wireless communication interface may include, but is not limited to, a Bluetooth communication unit, a Bluetooth Low Energy (BLE) communication unit, a near-field communication (NFC) unit, a wireless local area network (WLAN) (e.g., Wi-Fi) communication unit, a Zigbee communication unit, an Infrared Data Association (IrDA) communication unit, a Wi-Fi Direct (WFD) communication unit, an ultra-wideband (UWB) communication unit, an Ant+ communication unit, or the like. In a case in which the cooking vessel 101 is remotely controlled by a server device (not shown) in an Internet-of-Things (IoT) environment, the long-range communication unit may be used to communicate with the server device. The long-range wireless communication interface may include the Internet, a computer network (e.g., a local area network (LAN) or a wide area network (WAN)), and a mobile communication unit. The mobile communication unit may include, but is not limited to, a 3^{rd} Generation (3G) module, a 4^{th} Generation (4G) module, a 5^{th} Generation (5G) module, a Long-Term Evolution (LTE) module, a Narrowband IoT (NB-IoT) module, an LTE for Machines (LTE-M) module, and the like.

According to an embodiment of the present disclosure, the cooking vessel 101 may transmit information to a server device (not shown) via the induction heating device 2000. For example, the cooking vessel 101 may transmit information obtained from the cooking vessel 101 (e.g., temperature information of the contents) to the induction heating device 2000 through short-range wireless communication (e.g., Bluetooth or BLE). In this case, the induction heating device 2000 may transmit the information obtained from the cooking vessel 101 to the server device by using a WLAN communication unit or a long-range communication unit (e.g., the Internet) to connect to the server device. In addition, the server device may provide the information obtained from the cooking vessel 101 and received from the induction heating device 2000 to a user via a mobile terminal (not shown) connected to the server device. According to another embodiment of the present disclosure, the induction heating device 2000 may directly transmit the information obtained from the cooking vessel 101 to the user's mobile terminal via device-to-device (D2D) communication (e.g., WFD communication or BLE communication).

In addition, according to an embodiment of the present disclosure, the cooking vessel 101 may directly transmit information about the cooking vessel 101 (e.g., temperature information of the contents) to the server device via a communication interface (e.g., a WLAN (Wi-Fi) communication unit). In addition, the cooking vessel 101 may directly transmit the information obtained from the cooking vessel 101 (e.g., temperature information of the contents) to the user's mobile terminal via short-range wireless communication (e.g., Bluetooth or BLE) or D2D communication (e.g., WFD communication).

The induction heating device 2000 according to an embodiment of the present disclosure may be a device capable of wirelessly transmitting power to an object to be heated (e.g., the cooking vessel 101), which is located on a top plate of the induction heating device 2000 by using electromagnetic induction. The induction heating device 2000 may include a working coil that generates a magnetic field for inductively heating the cooking vessel 101. The working coil is a coil for generating a magnetic field via the flow of electricity, and may also be referred to as a heating coil throughout the present disclosure.

The generation of a magnetic field by a heating coil may mean that power is transferred by using a magnetic field that is induced in an IH metal (e.g., an iron component) via a magnetic induction method. For example, the induction heating device 2000 may cause an eddy current to be generated in the cooking vessel 101 by passing a current through the heating coil to form a magnetic field, thereby causing the cooking vessel 101 to be heated.

According to an embodiment of the present disclosure, the induction heating device 2000 may include a plurality of heating coils. For example, in a case in which the top plate of the induction heating device 2000 includes a plurality of cooking zones, the induction heating device 2000 may include a plurality of heating coils corresponding to the plurality of cooking zones, respectively. In addition, the induction heating device 2000 may include a high-power cooking zone where a first heating coil is arranged on an inner side and a second heating coil is arranged on an outer side. The high-power cooking zone may include two or more heating coils.

The top plate of the induction heating device 2000 according to an embodiment of the present disclosure may be made of tempered glass, such as ceramic glass, to prevent it from being easily broken. Furthermore, the top plate of the induction heating device 2000 may include guide marks to indicate the cooking zones where the cooking vessel 101 is to be placed.

According to an embodiment of the present disclosure, the induction heating device 2000 may detect whether the cooking vessel 101 including a magnetic material is placed on the top plate. For example, the induction heating device 2000 may detect that the cooking vessel 101 is located on the top plate of the induction heating device 2000, based on a change in a current value (inductance) of the heating coil caused by the proximity of the cooking vessel 101. The induction heating device 2000 may include a vessel detection sensor or a vessel detection coil to detect the presence and/or position of the cooking vessel 101.

According to an embodiment of the present disclosure, the induction heating device 2000 may include a communication interface for communicating with an external device. For example, the induction heating device 2000 may communicate with the cooking vessel 101 or a server device via the communication interface. The communication interface may include a short-range communication unit (e.g., an NFC communication unit, a Bluetooth communication unit, or a BLE communication unit), a mobile communication unit, or the like.

According to an embodiment of the present disclosure, the induction heating device 2000 may detect, via the communication interface, the cooking vessel 101 located on the top plate. For example, the induction heating device 2000 may detect the cooking vessel 101 by receiving a packet transmitted from the cooking vessel 101 located on the top plate, by using short-range wireless communication (e.g., BLE mesh network or Bluetooth).

According to an embodiment of the present disclosure, even in a case in which the cooking vessel 101 does not include a communication interface, the induction heating device 2000 may detect whether the cooking vessel 101 is placed on the top plate of the induction heating device 2000, via a vessel detection sensor (or a vessel detection coil).

According to an embodiment of the present disclosure, the induction heating device 2000 may display information related to the cooking vessel 101 via a user interface. For example, when the cooking vessel 101 is detected, the induction heating device 2000 may display identification information of the cooking vessel 101 and position information of the cooking vessel 101, on a display unit included in the user interface.

Referring to FIG. 1A, when a user places the cooking vessel 101 (e.g., a pot) on the top plate of the induction heating device 2000, the induction heating device 2000 may provide the user with identification information of the cooking vessel 101 (e.g., 'pot'), position information of the cooking vessel 101 (e.g., 'located on the right heating zone'), and material information of the cooking vessel 101 (e.g., whether it is a vessel that heats quickly), on a display 2411 that serves as an output interface.

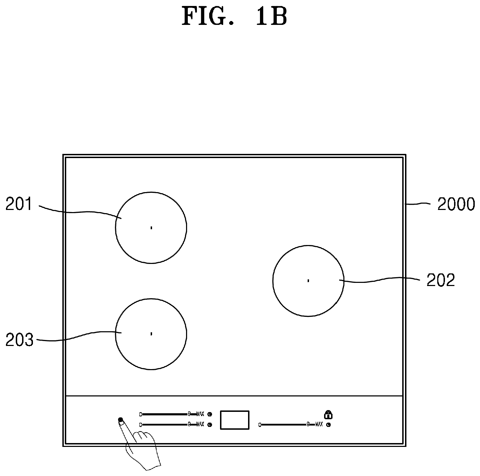

FIG. 1B is a diagram for describing an induction heating device according to an embodiment of the present disclosure.

FIG. 1B is a perspective view of the induction heating device 2000 of FIG. 1A without a cooking vessel. The induction heating device 2000 of FIG. 1B may include a plurality of heating zones 201, 202, and 203, and thus may simultaneously heat a plurality of cooking vessels. When the induction heating device 2000 simultaneously heats a plurality of cooking vessels, the heating coils corresponding to the respective heating zones may operate. The induction heating device 2000 of FIGS. 1A and 1B is a type of induction heating device in which the heating zones corresponding to cooking vessels are predetermined.

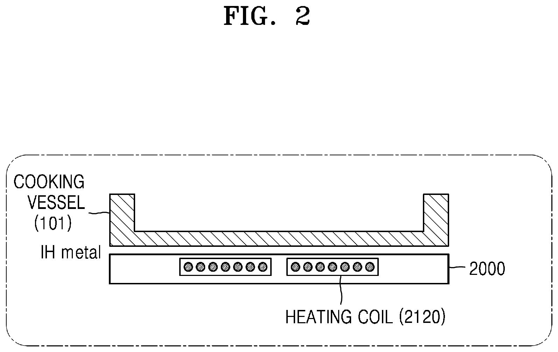

FIG. 2 is a cross-sectional view illustrating a state in which a cooking vessel is placed on an induction heating device, according to an embodiment of the present disclosure.

Referring to FIG. 2, the cooking vessel 101 may include a magnetic material (e.g., an IH metal) in which a magnetic field may be induced.

The cooking vessel 101 may be inductively heated by the induction heating device 2000, and may be any of various types of vessels that include a magnetic material. **IH** refers to a method of heating an IH metal by using electromagnetic induction. For example, when an alternating current is supplied to a heating coil 2120 of the induction heating device 2000, a time-varying magnetic field is induced inside the heating coil 2120. The magnetic field generated by the heating coil 2120 passes through the bottom surface of the cooking vessel 101. When the time-varying magnetic field passes through the IH metal (e.g., iron, steel, nickel, or various types of alloys) included in the bottom surface of the cooking vessel 101, a current that rotates around the magnetic field is generated in the IH metal. The rotating current is referred to as an eddy current, and the phenomenon in which a current is induced by a time-varying magnetic field is referred to as electromagnetic induction. In the case of the cooking vessel 101, heat is generated at the bottom surface of the cooking vessel 101 by the eddy current and the resistance of the IH metal (e.g., iron). At this time, the contents of the cooking vessel 101 may be heated by the generated heat.

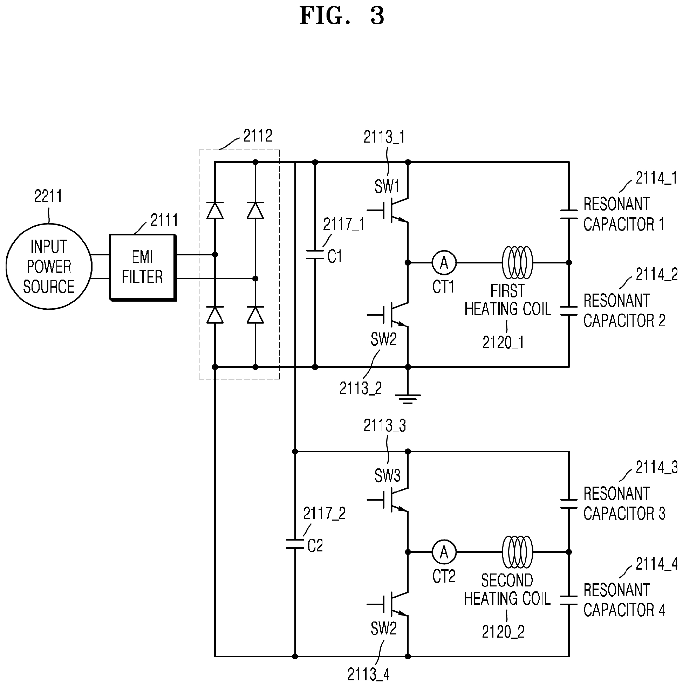

FIG. 3 is a circuit diagram of an inverter of an induction heating device for operating a plurality of heating coils, according to an embodiment of the present disclosure.

Referring to FIG. 3, an input power source 2211 is an alternating-current power source. An alternating-current voltage from the input power source 2211, which is an alternating-current power source, is rectified by a rectifier circuit 2112 after passing through an electromagnetic interference (EMI) filter 2111. In the rectifier circuit 2112, although a diode is sometimes used as an element for converting an alternating-current voltage into a direct-current voltage, a thyristor or another type of switching element may be used instead. The voltage, which has been converted into a direct-current (DC) voltage by the rectifier circuit 2112, may be smoothed by DC link capacitors 2117_1 and 2117_2.

FIG. 3 illustrates two resonant circuits on the assumption that there are two heating coils 2120_1 and 2120_2, but in a case in which three heating coils are required for three heating zones, an additional resonant circuit may be added.

The DC voltage smoothed by the DC link capacitor 2117_1 is caused to resonate between the first heating coil 2120_1 and a resonant capacitor 1 2114_1 and a resonant capacitor 2 2114_2 by the switching operation of two switching elements SW1 2113_1 and SW2 2113_2, and a magnetic field is generated in the first heating coil 2120_1 by the resonance. The magnetic field generated in the first heating coil 2120_1 generates an eddy current in an IH cooking vessel placed on the first heating coil 2120_1, thereby heating the contents of the cooking vessel. CT1 is a current sensor for detecting a current flowing through the first heating coil 2120_1.

Similarly, the DC voltage smoothed by the lower DC link capacitor 2117_2 is caused to resonate between the second heating coil 2120_2 and a resonant capacitor 3 2114_3 and a resonant capacitor 4 2114_4 by the switching operation of two switching elements SW3 2113_3 and SW4 2113_4. A magnetic field is generated in the second heating coil 2120_2 by the resonance. The magnetic field generated in the second heating coil 2120_2 generates an eddy current in an IH cooking vessel placed on the second heating coil 2120_2, thereby heating the contents of the cooking vessel. CT2 is a current sensor for detecting a current flowing through the second heating coil 2120_2.

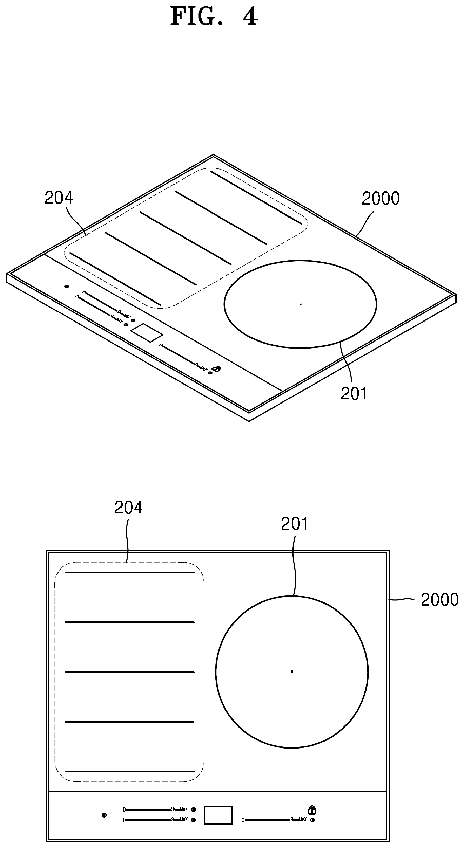

FIG. 4 illustrates an induction heating device using quadrangular heating coils, according to an embodiment of the present disclosure.

Referring to FIG. 4, the induction heating device 2000 according to an embodiment of the present disclosure may include a circular first heating zone 201 operated by circular heating coils, and a quadrangular heating zone 204 formed by quadrangular heating coils. The quadrangular shape may be a rectangle, and the heating coils at the bottom surface of the rectangular heating zone 204 may include a plurality of rectangular heating coils.

The use of quadrangular heating coils in the induction heating device 2000 has the advantage of eliminating non-cooking zones, for example, when placing a quadrangular pot thereon. In addition, no matter where the user of the induction heating device 2000 places a cooking vessel on the quadrangular heating zone 204, the induction heating device 2000 may recognize the cooking vessel and operate the quadrangular heating coils necessary for heating the cooking vessel, to heat the contents of the cooking vessel. Although FIG. 4 illustrates a case where the circular first heating zone 201 and the rectangular heating zone 204 are provided together, the induction heating device 2000 according to an embodiment of the present disclosure may include only quadrangular heating zones. In this case, the induction heating device 2000 is also referred to as an Anyplace induction heating device because it detects a cooking vessel and operates the heating coils regardless of where the cooking vessel is placed.

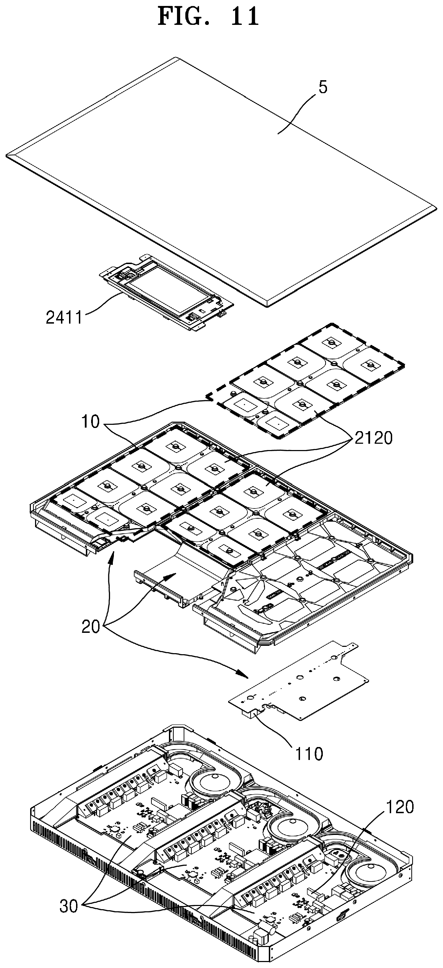

In an embodiment, the heating coils for the quadrangular heating zone 204 may include more finely divided heating coils, rather than the plurality of quadrangular heating coils illustrated in FIG. 4. For example, the heating coils for the quadrangular heating zone 204 may have a form in which small, circular heating coils are arranged in a relatively dense pattern. For example, the heating coils may have a form in which small heating coils are densely arranged, as in FIG. 11.

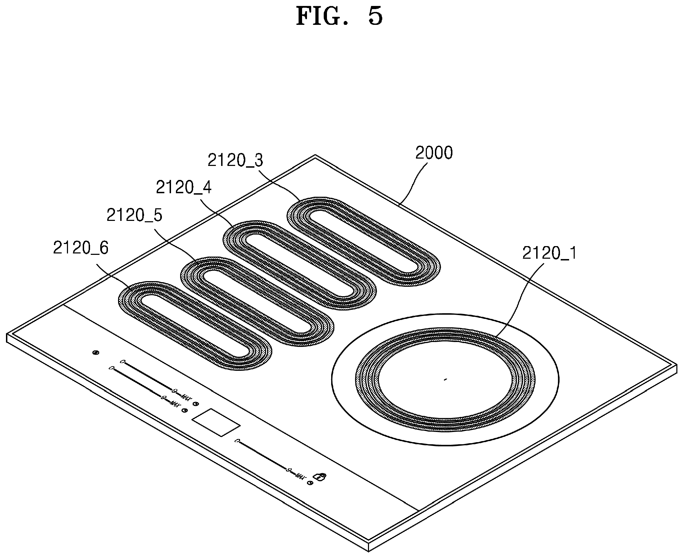

FIG. 5 is a diagram illustrating an induction heating device together with its heating coils, according to an embodiment of the present disclosure.

FIG. 5 illustrates a state in which the heating coils within the induction heating device 2000 are wound, in conjunction with the external appearance of the induction heating device 2000, although the heating coils are not actually visible from the outside. As illustrated in FIG. 5, according to an embodiment, four quadrangular heating coils 2120_3, 2120_4, 2120_5, and 2120_6, which correspond to the quadrangular heating zone 204 in the induction heating device 2000, are sequentially wound from an upper portion of the induction heating device 2000. This is only an embodiment, and the number of quadrangular heating coils 2120_3, 2120_4, 2120_5, and 2120_6 corresponding to the quadrangular heating zone 204 may be greater than four or may be less than four. In addition, in a case in which the induction heating device 2000 is an Anyplace induction heating device as described above, the circular heating coil 2120_1 may also be replaced by one or more quadrangular heating coils.

On the right side of the induction heating device 2000 of FIG. 5, the circular heating coil 2120_1 corresponding to the circular first heating zone 201 is wound, as illustrated in FIG. 1.

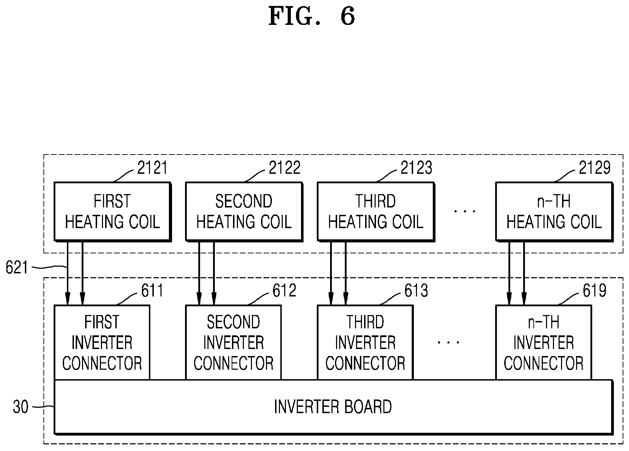

FIG. 6 is a diagram illustrating a structure in which heating coils are connected to an inverter board.

FIG. 6 shows that a first heating coil 2121, a second heating coil 2122, a third heating coil 2123, ..., and an n-th heating coil 2129 are respectively connected to a first inverter connector 611, a second inverter connector 612, a third inverter connector 613, ..., and an n-th inverter connector 619 on an inverter board 30.

As illustrated in FIG. 6, the first heating coil 2121, the second heating coil 2122, the third heating coil 2123, ..., and the n-th heating coil 2129 may be driven by an inverter on the inverter board 30 through electrical connections established by the first inverter connector 611, the second inverter connector 612, the third inverter connector 613, ..., and the n-th inverter connector 619 on the inverter board 30. Each heating coil is driven by the inverter to resonate with a resonant capacitor (not shown) on the inverter board 30, thereby heating a cooking vessel. The inverter board may also be referred to as an inverter printed board assembly (PBA).

In FIG. 6, the first heating coil 2121 is connected to the inverter board 410 via the first inverter connector 611, wherein the first heating coil 2121 and the first inverter connector 611 may be connected to each other via a wire 621. Similarly, the second heating coil 2122, the third heating coil 2123, ..., and the n-th heating coil 2129 may be respectively connected to the second inverter connector 612, the third inverter connector 613, ..., and the n-th inverter connector 619 via wires. In a case in which a plurality of heating coils all extend to be connected to respective inverter connectors via wires in this manner, a considerable length of wire is required, which increases manufacturing costs, and furthermore, the long wires may be entangled with each other, which may cause wire damage. This may lead to issues with poor wire quality, and poor wire quality may in turn lead to quality defects in the induction heating device. Moreover, because the connection and assembly of the wires for the heating coils are inherently difficult, securing sufficient area for circuit arrangement inside the induction heating device may be difficult. Furthermore, the difficulty in securing the area for circuit arrangement increases the complexity of circuit design, which may in turn reduce the productivity of the induction heating device.

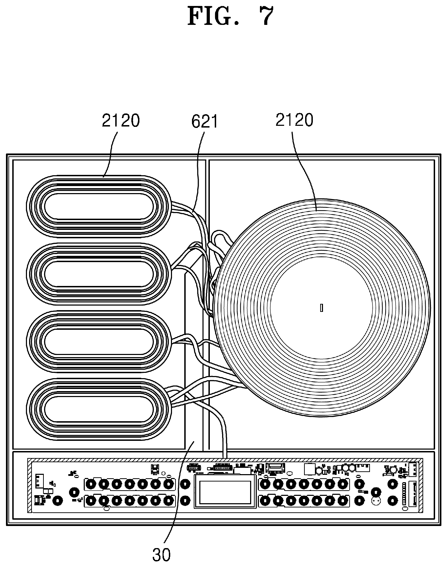

FIG. 7 is another diagram illustrating a structure in which heating coils are connected to an inverter board.

FIG. 7 illustrates a state in which heating coils 2120 are connected to the inverter board 30 via wires 621. In an embodiment, the inverter board 30 may be installed on the bottom surface of the induction heating device 2000. The inverter board 30 may include inverter connectors to which the wires 621 may be connected. The heating coils 2120 may be wound with copper, and an end of each heating coil 2120 is connected to the inverter board 30 via the wire 621, and as described above with reference to FIG. 6, in a case in which all of the heating coils 2120 are connected to the inverter board 30 via wires, a considerable length of wire is required, which increases manufacturing costs. Furthermore, the long wires may be entangled with each other, which may also cause wire damage. This may cause issues with poor wire quality and quality defects in the induction heating device.

Therefore, to solve this issue, an embodiment of the present disclosure may use a method of connecting boards to each other with fixed vertical connectors, that is, board-to-board connection, instead of connecting a plurality of heating coils and inverter connectors with wires. Furthermore, according to an embodiment of the present disclosure, the heating coils may also be fabricated in the form of a board to directly connect the heating coils to an inverter board or an intermediate board via a connector.

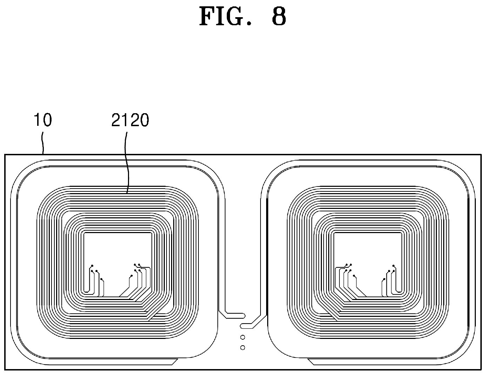

FIG. 8 illustrates a heating coil board of the induction heating device, according to an embodiment of the present disclosure.

FIG. 8 illustrates a heating coil board 10 on which the heating coils 2120 are patterned.

The heating coils may be fabricated in a form in which a conductor is printed on the heating coil board 10. In an embodiment, the heating coil board 10 on which two or more heating coil pattern layers are stacked may be used. To implement a high-power (exceeding a maximum of 3 kW) induction heating device by using the heating coil board 10 on which two or more heating coil pattern layers are stacked, the copper thickness of a single layer (i.e., the thickness of the coil pattern) needs to be about 500 µm. This may increase the influence of the skin effect, which may in turn increase coil loss. To achieve high power while reducing the skin effect, a method may be considered in which the thickness and width of the heating coil patterns are reduced and a plurality of heating coil patterns are connected in parallel to secure the required current capacity. In this case, the number of interlayer connections required to connect the plurality of heating coils in parallel may increase, and the heating coil loss due to wiring length may also increase. Therefore, according to an embodiment of the present disclosure, the heating coil board 10 may be employed that is formed by stacking multilayer heating coil pattern layers, which may reduce the number of interlayer connections while reducing heating coil loss. Here, "multilayer" may refer to four or more layers. In an embodiment, a pattern layer with the heating coil 2120 may be provided on the heating coil board 10 in the shape of a sheet. For example, the heating coil 2120 may be in the form of a PCB formed on the heating coil board 10 by a patterning process using a photoresist or the like. In an embodiment, the plurality of heating coils may have the same shape and size. The plurality of heating coils does not necessarily have the same shape and size.

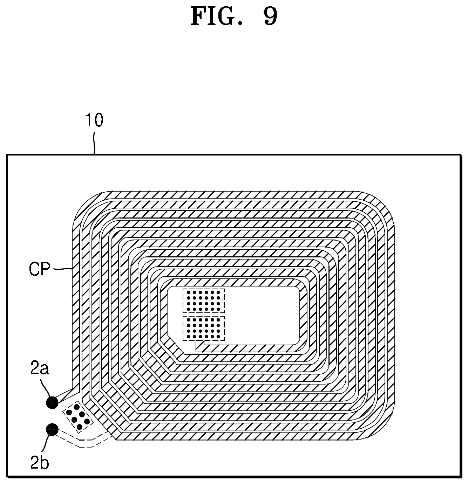

FIG. 9 is a plan view of a heating coil board according to an embodiment of the present disclosure.

Referring to FIG. 9, the heating coil board 10 may be a PCB fabricated by stacking six or more heating coil pattern layers (PL) on which coil patterns CP are formed. An insulating layer may be inserted between the heating coil pattern layers. According to the induction heating device 2000 having the heating coil board 10 as described above, because the heating coil board 10 has a stack structure with six or more layers, the thickness of the heating coil in a single layer, for example, the copper thickness, and the pattern width may be reduced, and thus, the influence of the skin effect and coil loss may be reduced. This is only an embodiment, and the heating coil board 10 may have a stack structure with three to five layers, which is fewer than six layers, or may have a stack structure with seven or more layers.

In the heating coil board 10, at least one coil pattern CP is formed on each heating coil pattern layer. For example, the coil pattern CP may be spiral. In an embodiment, the coil pattern CP may be formed by a plurality of coil elements that are substantially rectangular in a plan view, as illustrated in FIG. 9. In an embodiment, the coil pattern CP may be formed by a plurality of coil elements that are circular in a plan view. The shape of the coil elements that form the coil pattern CP is not limited to the aforementioned shapes. The heating coil board 10 may include a plurality of serial pattern groups across the plurality of heating coil pattern layers. The plurality of serial pattern groups may be connected to each other in parallel. The plurality of serial pattern groups may have a plurality of coil patterns CP connected in series, respectively. The plurality of serial pattern groups may be formed such that the coil patterns formed on adjacent pattern layers among the plurality of pattern layers are connected to each other in parallel. Through this configuration, the coils formed in the plurality of pattern layers may form a parallel connection, and the induction heating device 2000 may secure a large current capacity and reduce heating coil loss. The plurality of coil patterns CP respectively forming the plurality of serial pattern groups may be formed in four or more pattern layers. At least one of the plurality of serial pattern groups may have a different combination of the plurality of heating coil pattern layers from the other serial pattern groups. According to this configuration, the wiring structure between the plurality of heating coil pattern layers is simplified, which may reduce the number of interlayer connections and thereby reduce power loss. That is, by lowering the impedance gap between the parallel-connected serial pattern groups through the mutual impedance effect in each heating coil pattern layer, efficiency characteristics theoretically equivalent to those of an entire-layer (whole-layer) serial connection structure may be maintained. Furthermore, because the number of interlayer connections is reduced compared to the entire-layer serial connection structure, the interlayer wiring resistance is lowered, enabling a low-loss design with less loss than that of the entire-layer serial connection structure. The plurality of serial pattern groups may include at least two serial pattern groups having the same combination of the plurality of heating coil pattern layers. Through this, the number of interlayer connections may be reduced.

Furthermore, as illustrated in FIG. 9, in the heating coil board 10, two terminals (an input terminal 2a and an output terminal 2b) for connecting in parallel the plurality of serial pattern groups included in each stacked layer may be formed in outer peripheral portions of the coil pattern CP. In addition, electrical connections between the plurality of heating coil pattern layers may be established by a conductor (a through-hole (TH) or a via hole) formed to penetrate the heating coil board 10. The through-hole (TH) penetrates all heating coil pattern layers (PL) and enables electrical connection between the layers.

In addition, in the heating coil board 10 according to an embodiment of the present disclosure, the coil patterns CP may be provided such that the side of the input terminal 2a is located in the uppermost layer among the plurality of pattern layers (PL), and the side of the output terminal 2b is located in the lowermost layer among the plurality of pattern layers (PL). According to this configuration, in a case in which a low-power sensor is mounted in an upper layer when forming the plurality of heating coil pattern layers, the low-power sensor may be easily formed in a thin-film structure.

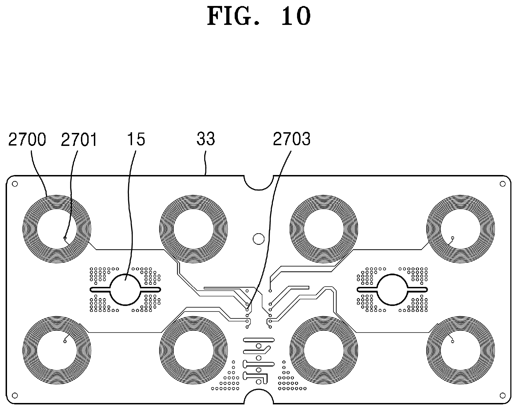

FIG. 10 illustrates a pattern layer including vessel detection coils, according to an embodiment of the present disclosure.

Referring to FIG. 10, according to an embodiment of the present disclosure, the heating coil board 10 includes a vessel detection coil layer 33 that includes vessel detection coils 2700.

The vessel detection coil layer 33 of FIG. 10 includes eight vessel detection coils 2700 as a pattern. In addition, according to an embodiment, the vessel detection coil layer 33 includes a hole 15 through which a temperature sensor capable of detecting the temperature of a cooking vessel may pass. In some cases, the hole 15 through which a temperature sensor may pass may not be included in the vessel detection coil layer 33. In the vessel detection coil layer 33 of FIG. 10, the pattern of the vessel detection coils 2700 has a circular shape and may be patterned and provided in a space that vertically overlaps with the heating coils patterned in another layer as little as possible. However, this is only an embodiment, and the pattern of the vessel detection coils 2700 may have a shape other than circular.

The vessel detection coil 2700 may include a first end 2701, which extends down to the lowermost layer through a via hole at the center of the circle in which the vessel detection coil 2700 is patterned, and a second end 2703 for connecting to a connector provided in the vessel detection coil layer 33. The induction heating device 2000 may detect whether a vessel is present on a top plate 5, based on a change in inductance measured via the first end 2701 and the second end 2703.

FIG. 11 illustrates a structure in which boards of an induction heating device are connected to each other, according to an embodiment of the present disclosure.

Referring to FIG. 11, the induction heating device 2000 according to an embodiment of the present disclosure may include the top plate 5 on which a cooking vessel is placed, and the heating coil board 10, which is arranged under the top plate 5 and on which a plurality of heating coils are printed, patterned, and stacked. The induction heating device 2000 according to an embodiment of the present disclosure may include an intermediate board 20 that is arranged under the heating coil board 10 and includes a relay, resonant capacitors, and the like. In an embodiment, the intermediate board 20 may include memory storing a program that controls the operation of the induction heating device 2000, and a processor configured to execute the program stored in the memory to control the induction heating device 2000.

The induction heating device 2000 according to an embodiment of the present disclosure may include the inverter board 30 that is arranged under the intermediate board 20 and includes an inverter and a power conversion device. According to an embodiment, the resonant capacitors may be included in the inverter board 30. In an embodiment, depending on design specifications, the intermediate board 20 and the inverter board 30 may be integrated into a single inverter board. The inverter board 30 may include a plurality of electronic switches that constitute the inverter. The plurality of electronic switches perform pulse-width modulation (PWM) switching. The heating coils 2120 included in the heating coil board 10 may induce an eddy current in a cooking vessel by resonating with the resonant capacitors via PWM switching. The inverter board 30 may include a power conversion device configured to generate a low DC voltage to be used for the processor, the memory, and the like included in the intermediate board 20. The power conversion device may also generate a voltage of 15 V or 12 V for switching of the plurality of electronic switches of the inverter. In the present disclosure, the power conversion device may be referred to as a switched-mode power supply (SMPS).

In an embodiment, the intermediate board 20 and the inverter board 30 may be electrically connected to each other by coupling, in a vertical direction, a first connector 110 vertically mounted on a lower surface of the intermediate board 20 to a second connector 120 vertically mounted on an upper surface of the inverter board 30. Here, in an embodiment, the electrical connection between the intermediate board 20 and the inverter board 30 may be established solely by the connection between the first connector 110 and the second connector 120.

The intermediate board 20 and/or the inverter board 30 may include a position guide to facilitate the coupling between the first connector 110 and the second connector 120 when the first connector 110 of the intermediate board 20 is coupled and connected to the second connector 120 of the inverter board 30.

In an embodiment, the first connector 110 vertically mounted on the lower surface of the intermediate board 20 may be a male connector, and the second connector 120 vertically mounted on the upper surface of the inverter board 30 may be a female connector. In an embodiment, conversely, the first connector 110 vertically mounted on the lower surface of the intermediate board 20 may be a female connector, and the second connector 120 vertically mounted on the upper surface of the inverter board 30 may be a male connector.

When the heating coil board 10, the intermediate board 20, and the inverter board 30 are connected to each other as illustrated in FIG. 11, wires for connecting between the boards are no longer necessary, and thus, product defects due to wires do not occur. In addition, it does not cause any inconvenience in assembly or increase in manufacturing costs due to wires. Therefore, the structure in which the boards are connected to each other by connectors, as illustrated in FIG. 11, simplifies product assembly and minimizes product defects.

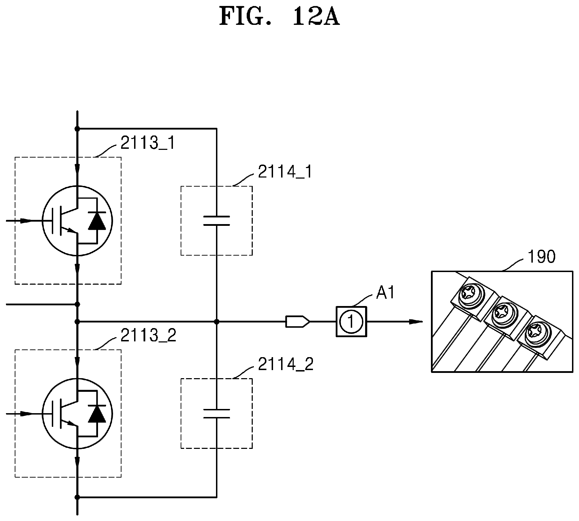

FIG. 12A is a diagram illustrating a structure in which connectors are fastened in an induction heating device.

FIG. 12A illustrates that the first switch 2113_1 and the second switch 2113_2, which are included in an inverter 2113, are respectively connected to the first resonant capacitor 2114_1 and the second resonant capacitor 2114_2. A point A1 connecting the first resonant capacitor 2114_1 and the second resonant capacitor 2114_2 of the inverter 2113 is connected to the heating coils 2120. The first resonant capacitor 2114_1 and the second resonant capacitor 2114_2 are caused to resonate with the heating coils 2120 by the operation of the first switch 2113_1 and the second switch 2113_2 included in the inverter 2113, and the induction heating device 2000 induces an eddy current in a cooking vessel through the resonance.

In FIG. 12A, the point A1 connecting the first resonant capacitor 2114_1 and the second resonant capacitor 2114_2 is connected to the heating coils 2120 via a screw-type terminal 190. The point A1 is connected to the heating coils 2120 via a wire fastened to the screw-type terminal 190. As mentioned above, this method results in complicated wire connections, which reduces the ease of assembly and increases the likelihood of product defects, in addition to increasing manufacturing costs.

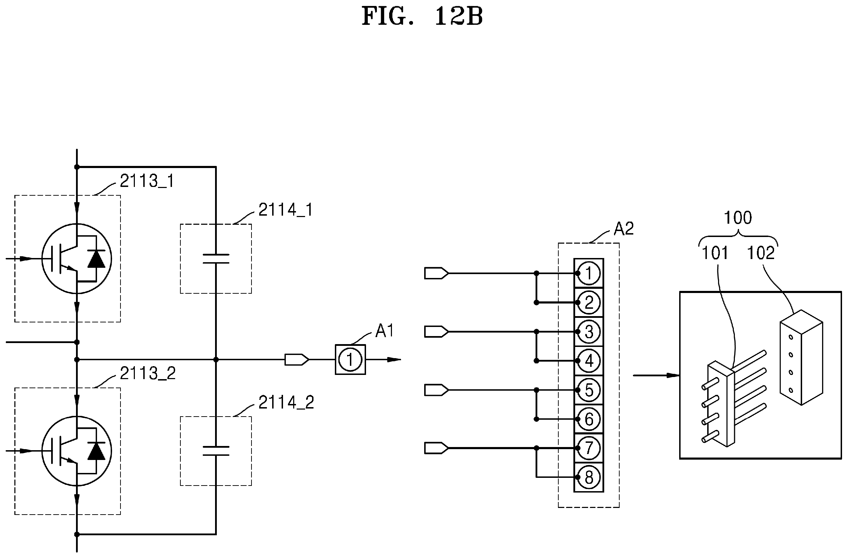

FIG. 12B is a diagram illustrating a structure in which connectors are fastened in an induction heating device, according to an embodiment of the present disclosure.

Similar to FIG. 12A, FIG. 12B illustrates a circuit in which the first switch 2113_1 and the second switch 2113_2, which are included in the inverter 2113, are respectively connected to the first resonant capacitor 2114_1 and the second resonant capacitor 2114_2. A point A2 connecting the first resonant capacitor 2114_1 and the second resonant capacitor 2114_2 of the inverter 2113 is connected to the heating coils 2120. The first resonant capacitor 2114_1 and the second resonant capacitor 2114_2 are caused to resonate with the heating coils 2120 by the operation of the first switch 2113_1 and the second switch 2113_2 included in the inverter 2113, and the induction heating device 2000 induces an eddy current in a cooking vessel through the resonance.

In FIG. 12B, the point A2 connecting the first resonant capacitor 2114_1 and the second resonant capacitor 2114_2 is connected to the heating coils 2120 via a connector 100. In an embodiment, the point A2 connecting the first resonant capacitor 2114_1 and the second resonant capacitor 2114_2 may be connected to a female connector 102 on the inverter board 30 including the inverter 2113, and may be coupled to a male connector 101 mounted on the heating coil 2120 to be connected to the heating coil 2120. In an embodiment, the point A2 connecting the first resonant capacitor 2114_1 and the second resonant capacitor 2114_2 may be connected to the male connector 101 on the inverter board 30 including the inverter 2113, and may be coupled to the female connector 102 mounted on the heating coil 2120 to be connected to the heating coil 2120. As mentioned above, this method involves no complicated wire connections, and thus improves the ease of assembly and lowers the possibility of product defects, as well as reducing the increase in manufacturing costs.

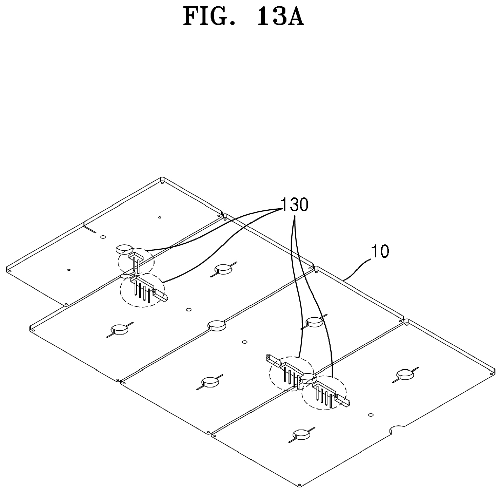

FIG. 13A is a diagram illustrating a structure in which connectors are connected to a heating coil board in an induction heating device, according to an embodiment of the present disclosure.

The heating coil board 10 is a board produced by stacking a plurality of heating coil board sheets on which a plurality of heating coils are patterned.

FIG. 13A shows the lower surface of the heating coil board 10 on which heating coil board connectors 130 are mounted, rather than the upper surface thereof on which the top plate 5 is placed. On the lower surface of the heating coil board 10, the heating coil board connectors 130 are vertically mounted such that the respective heating coils 2120 are electrically connected to the inverter 2113. The heating coil board connector 130 may be a male connector or a female connector. In the present disclosure, the heating coil board connector 130 may be referred to as a third connector to distinguish it from the first connector 110 and the second connector 120 illustrated in FIG. 11. In an embodiment, the heating coil board connector 130 may be directly connected to a connector vertically mounted on the inverter board 30 by passing through a hole in the intermediate board 20 of FIG. 11, or may be connected to a fourth connector 140 mounted on the intermediate board 20. In an embodiment, the heating coil board connector 130 is connected to the fourth connector 140 of the intermediate board 20 in cases in which resonant capacitors 2114 are mounted on the intermediate board 20.

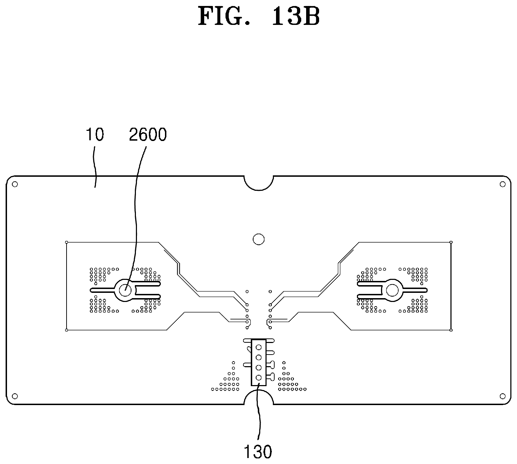

FIG. 13B is a diagram illustrating a structure in which connectors are mounted on the rear surface of a heating coil board in an induction heating device, according to an embodiment of the present disclosure.

Similar to FIG. 13A, FIG. 13B shows the lower surface of the heating coil board 10. The heating coil board 10 of FIG. 13B may include a hole penetrating the entire heating coil board 10 at a central portion where the heating coils 2120 are printed and patterned. The hole does not necessarily have to be located at the center and may be provided at other positions. A temperature sensor 2600 may be mounted in this hole. The temperature sensor 2600 may be used to measure the temperature of a cooking vessel placed on the top plate 5 of the induction heating device 2000.

The temperature sensor 2600 may include vertically fixed lead wires rather than a wire structure. The lead wires of the temperature sensor 2600 may be connected to a temperature sensor connector that is included in at least one board included in the heating coil board 10.

The heating coil board 10 may include the heating coil board connector 130 vertically mounted on the heating coil board 10 for electrical connection with the intermediate board 20 and/or the inverter board 30 placed under the heating coil board 10.

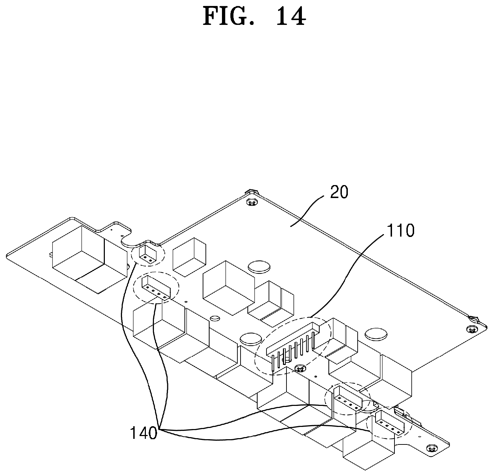

FIG. 14 is a diagram illustrating a structure in which connectors are connected to an intermediate board in an induction heating device, according to an embodiment of the present disclosure.

FIG. 14 shows the lower surface of the intermediate board 20 as viewed from below. The intermediate board 20 of FIG. 14 may be electrically connected to the heating coil board 10 of FIG. 13A by connectors. In an embodiment, the fourth connector 140 of the intermediate board 20 may be connected to the heating coil board connector 130 of the heating coil board 10 of FIG. 13A. In an embodiment, the fourth connector 140 of the intermediate board 20 may be mounted on the lower surface of the intermediate board 20. Alternatively, in an embodiment, depending on design specifications, the fourth connector of the intermediate board 20 may be a connector mounted on the upper surface of the intermediate board 20. According to an embodiment, to utilize the space between the intermediate board 20 and the inverter board 30, the fourth connector 140 of the intermediate board 20 may be mounted on the lower surface of the intermediate board 20. By mounting the fourth connector 140 on the lower surface of the intermediate board 20, the difficulty of adjusting the space between the heating coil board 10 and the intermediate board 20 may also be resolved.

In a case in which the heating coil board connector 130 of the heating coil board 10 of FIG. 13A is a male connector, the fourth connector 140 of FIG. 14 may be a female connector, and conversely, in a case in which the heating coil board connector 130 of the heating coil board 10 of FIG. 13A is a female connector, the fourth connector 140 of FIG. 14 may be a male connector. When the heating coil board connector 130 is received by the fourth connector, the heating coil 2120 may be electrically connected to the resonant capacitor 2114 of the intermediate board 20 without wires.

In an embodiment, the intermediate board 20 may include the first connector 110 that may be electrically connected to the inverter board 30. In an embodiment, the first connector 110 may be vertically mounted on the lower surface of the intermediate board 20, and may be coupled to the second connector 120 mounted on the inverter board 30, which is placed under the intermediate board 20, to allow the intermediate board 20 to be electrically connected to the inverter board 30. Although the first connector 110 is illustrated as a male connector in FIG. 14, the first connector 110 may be a female connector. In a case in which the first connector 110 is a male connector, the second connector 1200 on the inverter board 30 may be a female connector, and conversely, in a case in which the first connector 110 is a female connector, the second connector 120 on the inverter board 30 may be a male connector.

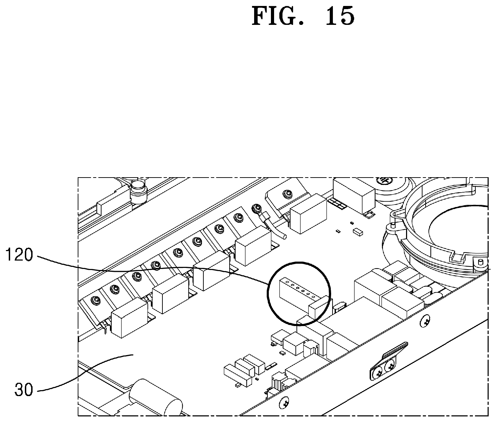

FIG. 15 is a diagram illustrating a structure in which a connector is connected to an inverter board in an induction heating device, according to an embodiment of the present disclosure.

Referring to FIG. 15, the second connector 120 is mounted on the upper surface of the inverter board 30. In an embodiment, the second connector 120 is coupled to the first connector 110 of the intermediate board 20 of FIG. 14, thereby enabling an electrical connection between the intermediate board 20 and the inverter board 30.

In an embodiment, the inverter board 30 may include the resonant capacitors 2114. When the inverter board 30 needs to be directly connected to the heating coil board 10 for resonance, the second connector 120, serving as a first inverter board connector, may be directly connected to the heating coil board connector 130. In this case, the heating coil board connector 130 may pass through a hole in the intermediate board 20 to be directly connected to the first inverter board connector on the inverter board 30. Alternatively, in an embodiment, the intermediate board 20 and the inverter board 30 may be integrated into a single board.

In an embodiment, when the second connector 120, serving as a first inverter board connector, is directly connected to the heating coil board connector 130, and the intermediate board 20 is present, the intermediate board 20 may be electrically connected to the inverter board 30 by coupling between an intermediate board connector 150 vertically mounted on the intermediate board 20 and a second inverter board connector 160 vertically mounted on the inverter board 30.

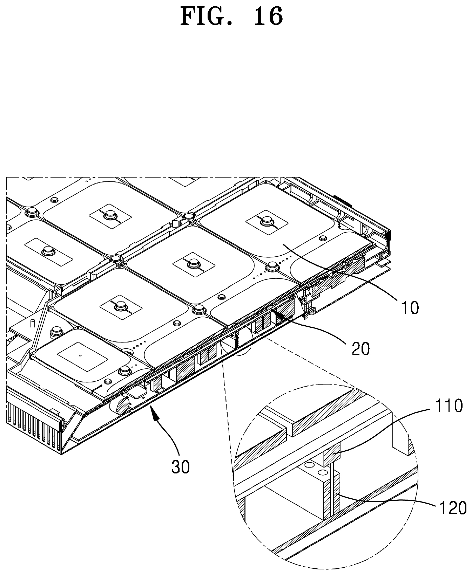

FIG. 16 is a diagram illustrating a structure in which boards are connected to each other by connectors in an induction heating device, according to an embodiment of the present disclosure.

FIG. 16 shows that the intermediate board 20 and the inverter board 30 of the induction heating device 2000 are connected to each other via connectors, according to an embodiment of the present disclosure. The first connector 110 of the intermediate board 20 is vertically connected to the second connector 120 of the inverter board 30.

As the intermediate board 20 and the inverter board 30 are coupled to each other by connectors vertically mounted on the boards without wires, the board connection efficiency of the induction heating device 2000 may be increased, and the ease of assembly may also be improved.

In an embodiment, the intermediate board 20 and the inverter board 30 may be combined into a single inverter board. In this case, the heating coil board 10 may be electrically connected to the single inverter board via a connector.

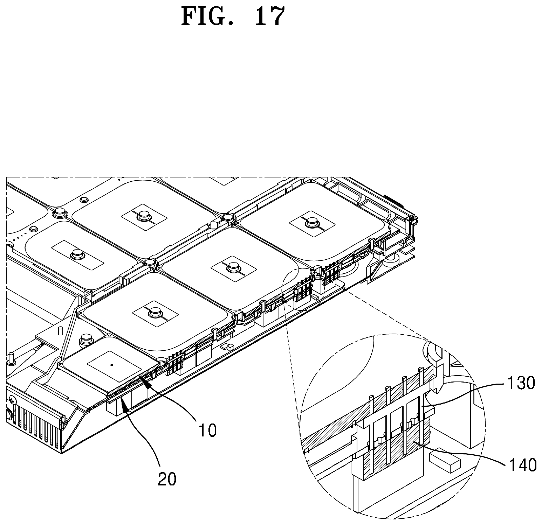

FIG. 17 is a diagram illustrating a structure in which a heating coil board and an intermediate board are connected to each other in an induction heating device, according to an embodiment of the present disclosure.

According to an embodiment of the present disclosure illustrated in FIG. 17, a third connector 130 mounted on the lower surface of the heating coil board 10 may be connected to a fourth connector 140 installed on the lower surface of the intermediate board 20, such that the heating coil board 10 and the intermediate board 20 are electrically connected to each other. According to this structure, the heating coil board 10 may be stacked in close contact with the intermediate board 20.

In an embodiment, the fourth connector 140 may be mounted on the upper surface of the intermediate board 20. In this case, the third connector 130 mounted on the lower surface of the heating coil board 10 may be coupled to the fourth connector 140 mounted on the upper surface of the intermediate board 20, such that the two boards are electrically coupled to each other.

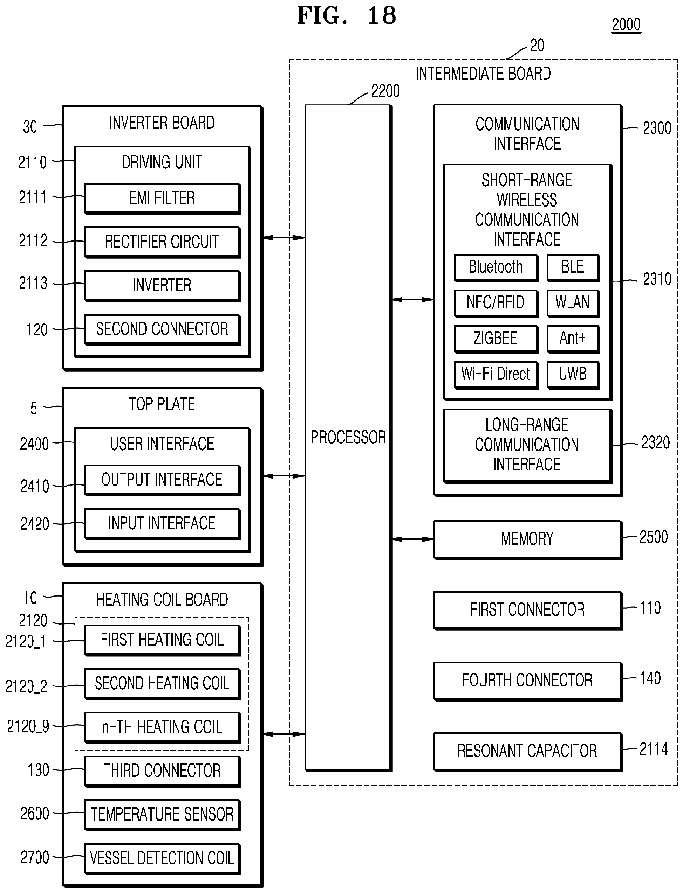

FIG. 18 is a block diagram of an induction heating device according to an embodiment of the present disclosure.

As illustrated in FIG. 18, the induction heating device 2000 according to an embodiment of the present disclosure may include the top plate 5, the heating coil board 10, the intermediate board 20, and the inverter board 30.

In the induction heating device 2000 according to an embodiment of the present disclosure, the top plate 5 is a plate on which a cooking vessel is placed and is typically made of heat-resistant tempered glass. The top plate 5 may include a user interface 2400 including an output interface 2410, such as a display, and an input interface 2420, such as a touch button. In an embodiment, the actual operation of the output interface 2410, such as a display, and the input interface 2420, such as a touch button, may be performed under control of a processor 2200, which will be described below. In an embodiment, a display or an actual touch button may be mounted on the intermediate board 20, and only the interfaces may be provided through the top plate 5.

The output interface 2410 is for outputting an audio signal or a video signal, and may include a display, an audio output unit, and the like.

In a case in which a display and a touch pad constitute a layer structure to form a touch screen, the display may serve as the input interface 2420 in addition to the output interface 2410. The display may include at least one of a liquid-crystal display, a thin-film-transistor liquid-crystal display, a light-emitting diode (LED) display, an organic LED display, a flexible display, a three-dimensional (3D) display, and an electrophoretic display. Depending on the implementation of the induction heating device 2000, the induction heating device 2000 may include two or more displays.

The audio output unit may output audio data received from a communication interface 2300 or stored in memory 2500. In addition, the audio output unit may output an audio signal related to a function performed by the induction heating device 2000. The audio output unit may include a speaker, a buzzer, or the like.

According to an embodiment of the present disclosure, the output interface 2410 may display information about the cooking vessel 101. For example, the output interface 2410 may output a graphical user interface (GUI) corresponding to identification information or product type information of the cooking vessel 101. In addition, the output interface 2410 may output information about the current position of the cooking vessel 101 and/or material information of the cooking vessel 101.

The input interface 2420 is for receiving an input from a user. The input interface 2420 may be, but is not limited to, at least one of a key pad, a dome switch, a touch pad (e.g., a touch-type capacitive touch pad, a pressure-type resistive overlay touch pad, an infrared sensor-type touch pad, a surface acoustic wave conduction touch pad, an integration-type tension measurement touch pad, a piezoelectric effect-type touch pad), a jog wheel, and a jog switch.

The input interface 2420 may include a speech recognition module. For example, the induction heating device 2000 may receive, through a microphone, a voice signal, which is an analog signal, and convert a speech part into a computer-readable text by using an automatic speech recognition (ASR) model. The induction heating device 2000 may interpret the text by using a natural language understanding (NLU) model to obtain an utterance intention of the user. Here, the ASR model or the NLU model may be an artificial intelligence model. The artificial intelligence model may be processed by an artificial intelligence-dedicated processor designed in a hardware structure specialized for processing an artificial intelligence model. The artificial intelligence model may be generated via a training process. Here, being generated via a training process may mean that predefined operation rules or artificial intelligence model set to perform desired characteristics (or purposes), is generated by training a basic artificial intelligence model by using a learning algorithm that utilizes a large amount of training data. The artificial intelligence model may include a plurality of neural network layers. Each of the neural network layers has a plurality of weight values, and performs a neural network arithmetic operation via an arithmetic operation between an arithmetic operation result of a previous layer and the plurality of weight values.

Linguistic understanding is a technology for recognizing and applying/processing human language/characters, and includes natural language processing, machine translation, dialogue system, question answering, speech recognition/synthesis, and the like.

In the induction heating device 2000 according to an embodiment of the present disclosure, the heating coil board 10 may include the heating coils 2120 that are printed and patterned on a heating coil board sheet 11. The heating coil board 10 may have a structure in which a plurality of heating coil board sheets 11 are stacked. The heating coils 2120 may be a plurality of heating coils, and the heating coils 2120 may include a first heating coil 2120_1, a second heating coil 2120_2, ..., and an n-th heating coil 2120_9 (where n is a natural number of 2 or greater). The heating coil board 10 may include the third connector 130 for connection to the intermediate board 20 and/or the inverter board 30 without wires.

The heating coil 2120 may generate a magnetic field for heating the cooking vessel 101. For example, when a current is supplied to the heating coil 2120, a magnetic field may be induced around the heating coil 2120. When a current that changes in magnitude and direction over time, i.e., an alternating current, is supplied to the heating coil 2120, a magnetic field that changes in magnitude and direction over time may be induced around the heating coil 2120. The magnetic field around the heating coil 2120 may pass through the top plate 5 made of tempered glass and reach the cooking vessel 101 placed on the top plate 5. An eddy current rotating around the magnetic field may be generated in the cooking vessel 101 due to the magnetic field that changes in magnitude and direction over time, and resistance heat may be generated in the cooking vessel 101 due to the eddy current. Resistance heat is heat generated in a resistor when a current flows therethrough, and is also referred to as Joule heat. When the cooking vessel 101 is heated by the electrical resistance heat, the contents of the cooking vessel 101 may be heated.

In the induction heating device 2000 according to an embodiment of the present disclosure, the heating coil board 10 may further include the temperature sensor 2600. The temperature sensor 2600 is a sensor that senses the temperature of the top plate 5 or of the cooking vessel 101 placed on the top plate 5. The processor 2200 may determine whether the cooking vessel 101 is being empty-heated or overheated, based on the temperature of the cooking vessel 101 sensed by the temperature sensor 2600. In an embodiment, the temperature sensor 2600 may be installed in a hole penetrating the heating coil board 10. The temperature sensor 2600 may be fixed to the board by a fixed lead wire, rather than being connected to the board by a wire. In an embodiment, two lead wires of the temperature sensor 2600 may be vertically received, without a wire, into a connector mounted on at least one heating coil board 10. For example, a female connector may be mounted on at least one heating coil board 10, and the lead wires of the temperature sensor 2600 may be directly connected to the female connector mounted on the at least one heating coil board 10 without soldering.

In the induction heating device 2000 according to an embodiment of the present disclosure, the heating coil board 10 may further include the vessel detection coil 2700. In an embodiment, the vessel detection coil 2700 may be configured in the form of a pattern that is printed on the heating coil board sheet 11 along with the heating coils 2120. In an embodiment, the vessel detection coil 2700 may be printed on the uppermost layer of the heating coil board 10, which is closest to the top plate 5. In this case, the uppermost layer of the heating coil board 10 may be configured as a layer that includes only the vessel detection coil 2700, without heating coils 2120. The processor 2200 of the induction heating device 2000 may detect, via the vessel detection coil 2700, whether the cooking vessel 101 is placed on the top plate 5 of the induction heating device 2000.

The inverter board 30 may include a driving unit 2110. The driving unit 2110 may receive power from the input power source 2211 and supply a current to the heating coil 2120 according to a drive control signal from the processor 2200. The driving unit 2110 may include, but is not limited to, the EMI filter 2111, the rectifier circuit 2112, the inverter 2113, and the second connector 120. In an embodiment, the inverter board 30 may further include the resonant capacitor 2114.

The EMI filter 2111 may block high-frequency noise included in alternating-current power supplied from the input power source 2211, and allow an alternating-current voltage and an alternating current of a predetermined frequency (e.g., 50 Hz or 60 Hz) to pass through. A fuse and a relay for blocking overcurrent may be provided between the EMI filter 2111 and the input power source 2211. The alternating-current power from which high-frequency noise is filtered out by the EMI filter 2111 is supplied to the rectifier circuit 2112.

The rectifier circuit 2112 may convert the alternating-current voltage into a direct-current voltage. For example, the rectifier circuit 2112 may convert an alternating-current voltage that changes in magnitude and polarity (i.e., positive voltage or negative voltage) over time, into a direct-current voltage with a constant magnitude and polarity, and may convert an alternating current that changes in magnitude and direction (i.e., positive current or negative current) over time, into a direct current that does not change in polarity over time. The rectifier circuit 2112 may include a diode as an element for rectification. For example, the rectifier circuit 2112 may include four diodes. The diode may convert an alternating-current voltage that changes in polarity over time, into a positive voltage with a constant polarity, and may convert an alternating current that changes in direction over time, into a positive current with a constant direction. The rectifier circuit 2112 may be connected to a DC link capacitor that smooths the rectified direct-current voltage.

The inverter 2113 may include a switching circuit that supplies or blocks a driving current to the heating coil 2120. In the inverter 2113, resonance between the heating coil 2120 and the resonant capacitor 2114 may be generated by the switching operation of the switching circuit. In an embodiment, the resonant capacitor 2114 may be included in the inverter board 30, or may be included in the intermediate board 20. The switching circuit may include two switches for each heating zone as illustrated in FIG. 12A. The first switch 2113_1 and the second switch 2113_2 illustrated in FIG. 12A may be turned on or off according to a driving control signal from the processor 2200. In an embodiment, the induction heating device 2000 may include, in addition to the processor 2200, a separate driving processor to generate a driving control signal.

The inverter 2113 may control a current supplied to the heating coil 2120. For example, the magnitude and direction of a current flowing in the first heating coil 2120_1 may change according to turning on or off of the first switch 2113_1 and the second switch 2113_2 included in the inverter 2113. In addition, the magnitude and direction of a current flowing in the second heating coil 2120_2 may change according to turning on or off of another pair of switches included in the inverter 2113. In this case, an alternating current may be supplied to the first heating coil 2120_1 and the second heating coil 2120_2.

In a case in which the induction heating device 2000 includes a plurality of heating coils 2120, i.e., the first heating coil 2120_1, the second heating coil 2120_2, ..., and the n-th heating coil 2120_9, as in FIG. 18, the inverter board 30 may include a distribution circuit (not shown). The distribution circuit may include a plurality of switches that pass or block a current supplied to the plurality of heating coils 2120, and the plurality of switches may be turned on or off according to a distribution control signal from the processor 2200.

The inverter board 30 may include the second connector 120, which serves as a connector for establishing a board-to-board connection with the intermediate board 20. The second connector 120 is connected to the first connector 110 of the intermediate board 20 to establish an electrical connection between the intermediate board 20 and the inverter board 30. The second connector 120 is a connector mounted on the inverter board 30, and thus may be referred to as an inverter board connector.

In the induction heating device 2000 according to an embodiment of the present disclosure, the intermediate board 20 may be located between the heating coil board 10 and the inverter board 30. In a case in which the inverter board 30 is a second board, the intermediate board 20 may be a first board. According to an embodiment, the intermediate board 20 may include, but is not limited to, the processor 2200, the communication interface 2300, the memory 2500, the first connector 110, and the fourth connector 140. For example, the intermediate board 20 may further include the resonant capacitor 2114, and the fourth connector 140 may be connected to the third connector 130 of the heating coil board 10 for resonance. In addition, components included in the intermediate board 20 may be electrically connected to components included in the inverter board 30 as the first connector 110 is connected to the second connector 120 of the inverter board 30.

According to an embodiment, the intermediate board 20 may include the resonant capacitor 2114. This is only an embodiment, and the resonant capacitor 2114 may be included in the inverter board 30 depending on design specifications. The resonant capacitor 2114 may induce an eddy current in the cooking vessel 101 placed on the top plate 5 of the induction heating device 2000 by resonating with the heating coil 2120 through switching of the inverter 2113. In a case in which a plurality of heating coils 2120 are provided, a plurality of resonant capacitors 2114 may be provided to correspond to the heating coils 2120, respectively. Because an electrical connection between the two boards is required for the resonant capacitor 2114 to resonate with the heating coil 2120 of the heating coil board 10, the intermediate board 20 may include the fourth connector 140, which is connected to the third connector 130 of the heating coil board 10.

The processor 2200 of the intermediate board 20 may determine the switching frequency (i.e., a turn-on/turn-off frequency) of the switching circuit included in the inverter 2113 based on the output strength (power level) of the induction heating device 2000. The processor 2200 may generate a driving control signal for turning on or off the switching circuit according to the determined switching frequency. The induction heating device 2000 may include a driving processor that is separate from the processor 2200, for controlling the operation of the driving unit 2110 including the inverter 2113 during the operation of the processor 2200.

The processor 2200 controls the overall operation of the induction heating device 2000.

The processor 2200 is a hardware device that controls the overall operation of the induction heating device 2000. The processor 2200 may include one processor or a plurality of processors. The processor 2200 according to an embodiment of the present disclosure may be a hardware processing circuit including at least one of a central processing unit (CPU), a graphics processing unit (GPU), an accelerated processing unit (APU), a many-integrated core (MIC), a digital signal processor (DSP), an integrated circuit, and a neural processing unit (NPU). The processor 2200 may be implemented in the form of an integrated system on a chip (SoC) including one or more electronic components. In a case in which the processor 2200 includes a plurality of processors, each processor may be implemented as separate hardware (H/W). The processor 2200 may be referred to as a microprocessor controller (MICOM), a microprocessor unit (MPU), or a microcontroller unit (MCU). The processor 2200 according to an embodiment of the present disclosure is a hardware device that may be implemented as a single-core processor or a multi-core processor. The processor 2200 may execute programs stored in the memory 2500 to control the driving unit 2110, the communication interface 2300, the user interface 2400, and the memory 2500.

According to an embodiment of the present disclosure, the induction heating device 2000 may be equipped with an artificial intelligence (AI) processor. The AI processor may be manufactured in the form of a dedicated hardware chip for AI, or may be manufactured as part of an existing general-purpose processor (e.g., a CPU or an application processor) or a dedicated graphics processor (e.g., a GPU), and then mounted on the induction heating device 2000.

In a case in which unique identification information of the cooking vessel 101 is stored in the memory 2500, the processor 2200 may establish a short-range wireless communication channel (e.g., a BLE communication channel) with the cooking vessel 101 via the communication interface 2300.

The processor 2200 may perform asymmetric control between the plurality of heating coils 2120. In an embodiment, when the operating frequency of the first heating coil 2120_1 is f₁ and the operating frequency of the second heating coil 2120_2 is f₂ (f₁ < f₂), the processor 2200 may control the operating frequency of the second heating coil 2120_2 such that f₂ = f₁. At the same time, the processor 2200 may perform asymmetric control to set the turn-on/turn-off duties of the third switch 2113_3 and the fourth switch 2113_4 differently when the operating frequency is f₁ such that the output of the heating zone corresponding to the second heating coil 2120_2 when the operating frequency of the second heating coil 2120_2 is f₂ is identical to the output when the operating frequency of the second heating coil 2120_2 is f₁.

The communication interface 2300 of the intermediate board 20 may include one or more components that enable communication between the induction heating device 2000 and the cooking vessel 101, between the induction heating device 2000 and a server device (not shown), or between the induction heating device 2000 and a user terminal (not shown). For example, the communication interface 2300 may include a short-range wireless communication interface 2310 and a long-range communication interface 2320. The short-range wireless communication interface 2310 may include, but is not limited to, a Bluetooth communication unit, a BLE mesh network communication unit, an NFC unit, a WLAN (e.g., Wi-Fi) communication unit, a Zigbee communication unit, an IrDA communication unit, a WFD communication unit, a UWB communication unit, an Ant+ communication unit, or the like. In a case in which the cooking vessel 101 is remotely controlled by a server device (not shown) in an IoT environment, the long-range communication interface 2320 may be used to communicate with the server device. The long-range communication interface 2320 may include the Internet, a computer network (e.g., a LAN or a WAN), and a mobile communication unit. The mobile communication unit transmits and receives radio signals to and from at least one of a base station, an external terminal, or a server, on a mobile communication network. Here, the radio signals may include a voice call signal, a video call signal, or various types of data according to text/multimedia message transmission and reception. The mobile communication unit may include, but is not limited to, a 3G module, a 4G module, an LTE module, a 5G module, a 6G module, an NB-IoT module, an LTE-M module, or the like.

The memory 2500 may store a program for the processor 2200 to perform the operation and control of the induction heating device 2000, and may store input/output data (e.g., unique identification information of the cooking vessel 101, variable identification information of the cooking vessel 101, a plurality of power transmission patterns, cooking progress information of the cooking vessel 101, or material information of the cooking vessel 101). The memory 2500 may store coded instructions related to switching operations for driving the inverter 2113. In addition, the memory 2500 may also store an AI model.

The memory 2500 may include at least one of a flash memory-type storage medium, a hard disk-type storage medium, a multimedia card micro-type storage medium, a card-type memory (e.g., SD or XD memory), random-access memory (RAM), static RAM (SRAM), read-only memory (ROM), electrically erasable programmable ROM (EEPROM), programmable ROM (PROM), magnetic memory, a magnetic disk, and an optical disc. In addition, the induction heating device 2000 may operate a web storage or a cloud server that performs a storage function on the Internet.

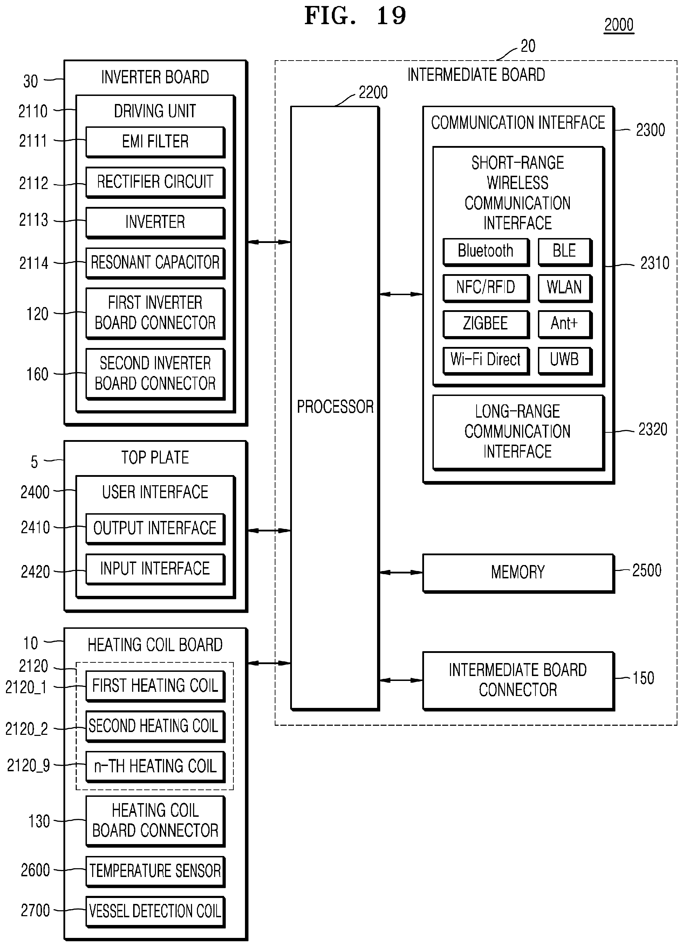

FIG. 19 is a block diagram of an induction heating device according to an embodiment of the present disclosure.

The difference between the induction heating device 2000 of FIG. 19 and the induction heating device of FIG. 18 is that the resonant capacitor 2114 is arranged on the inverter board 30. Thus, the heating coil board 10, which includes the heating coil 2120 that resonates with the resonant capacitor 2114, needs to be connected to the inverter board 30 by a connector. In an embodiment, as a heating coil board connector 130 mounted on the heating coil board 10 is coupled to a first inverter board connector 120 mounted on the inverter board 30, the heating coil board 10 may be electrically connected to the inverter board 30. All electrical connections between the heating coil board 10 and the inverter board 30 may be established by coupling between the heating coil board connector 130 and the first inverter board connector 120. In an embodiment, the heating coil board connector 130 may be vertically mounted on the heating coil board 10, and the first inverter board connector 120 may also be vertically mounted on the inverter board 30.

In an embodiment, in a case in which the intermediate board 20 is provided as a separate board, the heating coil board connector 130 may pass through a hole in the intermediate board 20 to be coupled to the first inverter board connector 120.

In a case in which the intermediate board 20 is separate from the inverter board 30, the intermediate board 20 may be electrically connected to the inverter board 30 by coupling the intermediate board connector 150 mounted on the intermediate board 20 to the second inverter board connector 160 mounted on the inverter board 30.

All electrical connections between the intermediate board 20 and the inverter board 30 may be established by coupling between the intermediate board connector 150 and the second inverter board connector 160. In an embodiment, the intermediate board connector 150 may be vertically mounted on the intermediate board 20, and the second inverter board connector 160 may also be vertically mounted on the inverter board 30.

In an embodiment, the intermediate board 20 may be combined with the inverter board 30 to form a single board. In this case, the heating coil board 10 may establish an electrical connection with the single integrated inverter board as the heating coil board connector 130 is coupled to the first inverter board connector 120 of the single integrated inverter board.

The single inverter board in which the intermediate board 20 is integrated with the inverter board 30 may include the memory 2500 storing a program for controlling the operation of the induction heating device 2000, the communication interface 2300, and the processor 2200 configured to execute the program stored in the memory to control the induction heating device 2000. In addition, the single integrated inverter board may further include a power converter for supplying power to the processor 2200, the memory 2500, and the like.

According to an embodiment of the present disclosure, disclosed is an induction heating device including a heating coil board formed by stacking a plurality of heating coil pattern layers on which heating coils are printed and patterned. According to an embodiment, the induction heating device may include an intermediate board arranged under the heating coil board and including resonant capacitors that resonate with the heating coils such that a magnetic field is generated in the heating coils. According to an embodiment, the induction heating device may include an inverter board that includes a switching inverter for generating resonance. According to an embodiment, the intermediate board may further include a first connector, and the inverter board may further include a second connector. According to an embodiment, an electrical connection between the intermediate board and the inverter board may be established based on the first connector and the second connector being connected to each other in a vertical direction.

According to an embodiment of the present disclosure, the heating coil board may include a third connector for electrical connection to the intermediate board. According to an embodiment, the intermediate board may include a fourth connector for connection to the third connector in a vertical direction. According to an embodiment, an electrical connection between the heating coil board and the intermediate board may be established solely by connection between the third connector and the fourth connector.

According to an embodiment of the present disclosure, the patterned heating coils included in the heating coil board resonate with the resonant capacitors of the intermediate board via the third connector.

According to an embodiment of the present disclosure, the third connector is vertically mounted on a lower surface of the heating coil board. According to an embodiment, the fourth connector is vertically mounted on a lower surface of the intermediate board.

According to an embodiment of the present disclosure, the third connector is mounted on the lower surface of the heating coil board. According to an embodiment, the fourth connector is mounted on the upper surface of the intermediate board.

According to an embodiment of the present disclosure, the third connector is a male connector mounted on the lower surface of the heating coil board, and the fourth connector is a female connector.

According to an embodiment of the present disclosure, the third connector is a female connector mounted on the lower surface of the heating coil board, and the fourth connector is a male connector.

According to an embodiment of the present disclosure, the first connector is a male connector mounted on the lower surface of the intermediate board, and the second connector is a female connector mounted on the inverter board.

According to an embodiment of the present disclosure, the first connector is a female connector mounted on the lower surface of the intermediate board, and the second connector is a male connector mounted on the inverter board.

According to an embodiment of the present disclosure, all electrical connections between the intermediate board and the inverter board are established solely by connection between the first connector and the second connector.

According to an embodiment of the present disclosure, the plurality of heating coil pattern layers are formed by stacking six or more pattern layers including an insulating layer, and the insulating layer is inserted between the heating coil pattern layers on which the heating coils are printed among the plurality of heating coil pattern layers.

According to an embodiment of the present disclosure, a vessel detection coil for detecting a cooking vessel may be printed on at least one heating coil pattern layer among the plurality of heating coil pattern layers included in the heating coil board.

According to an embodiment of the present disclosure, the at least one heating coil pattern layer on which the vessel detection coil is printed may be the pattern layer that is closest to a top plate on which a cooking vessel is placed, among the plurality of heating coil pattern layers.

According to an embodiment of the present disclosure, the induction heating device may further include a temperature sensor for sensing the temperature of a cooking vessel placed on the top plate.

According to an embodiment of the present disclosure, the temperature sensor may be arranged to pass vertically through the heating coil board.

According to an embodiment of the present disclosure, two lead wires of the temperature sensor may be connected, without a wire, to a temperature sensor connector mounted on at least one heating coil board.

According to an embodiment of the present disclosure, disclosed is an induction heating device including a heating coil board formed by stacking a plurality of heating coil pattern layers on which heating coils are printed and patterned. According to an embodiment, the heating coil board may further include at least one heating coil board connector. According to an embodiment, the induction heating device may include resonant capacitors that resonate with the heating coils, and at least one first inverter board connector that is connected to the at least one heating coil board connector in a vertical direction. According to an embodiment, the induction heating device may include an inverter board that includes an inverter for generating resonance between the heating coils and the resonant capacitors. According to an embodiment, an electrical connection between the heating coil board and the inverter board may be established solely by connection between the at least one heating coil board connector and the at least one first inverter board connector.

According to an embodiment of the present disclosure, the induction heating device may further include an intermediate board arranged between the heating coil board and the inverter board and including memory storing a program that controls an operation of the induction heating device, and a processor configured to execute the program stored in the memory to control the induction heating device. According to an embodiment, the intermediate board may include a hole through which the at least one heating coil board connector passes.

According to an embodiment of the present disclosure, the intermediate board may include at least one intermediate board connector for electrical connection to the inverter board. According to an embodiment, the inverter board may further include at least one second inverter board connector that is connected to the intermediate board connector in a vertical direction. According to an embodiment, an electrical connection between the intermediate board and the inverter board may be established solely by connection between the at least one intermediate board connector and the at least one second inverter board connector.

According to an embodiment of the present disclosure, the inverter board may include memory storing a program for controlling the operation of the induction heating device. According to an embodiment, the inverter board may include a processor configured to execute the stored program to control the induction heating device. According to an embodiment, the inverter board may include a power converter for supplying power to the processor and the memory.

A method according to an embodiment of the present disclosure may be embodied as program instructions executable by various computer devices, and then recorded on a computer-readable medium. The computer-readable medium may include program commands, data files, data structures, or the like separately or in combinations. The program commands to be recorded on the medium may be specially designed and configured for the present disclosure or may be well-known to and be usable by those skilled in the art of computer software. Examples of the computer-readable recording medium include magnetic media such as hard disks, floppy disks, or magnetic tapes, optical media such as a compact disc ROM (CD-ROM) or a digital video disc (DVD), magneto-optical media such as a floptical disk, and hardware devices such as ROM, RAM, or flash memory, which are specially configured to store and execute program instructions. Examples of program instructions include not only machine code, such as code made by a compiler, but also high-level language code that is executable by a computer by using an interpreter or the like.

Some embodiments of the present disclosure may be implemented as a recording medium including computer-readable instructions such as a computer-executable program module. The computer-readable medium may be any available medium which is accessible by a computer, and may include a volatile or non-volatile medium and a removable or non-removable medium. Also, the computer-readable medium may include a computer storage medium and a communication medium. The computer storage media include both volatile and non-volatile, removable and non-removable media implemented in any method or technique for storing information such as computer-readable instructions, data structures, program modules or other data. The communication media typically include computer-readable instructions, data structures, program modules, other data of a modulated data signal, or other transmission mechanisms, and examples thereof include an arbitrary information transmission medium. Also, some embodiments of the present disclosure may be implemented as a computer program or a computer program product including computer-executable instructions such as a computer program executed by a computer.

A machine-readable storage medium may be provided in the form of a non-transitory storage medium. Here, the term 'non-transitory storage medium' refers to a tangible device and does not include a signal (e.g., an electromagnetic wave), and the term 'non-transitory storage medium' does not distinguish between a case where data is stored in a storage medium semi-permanently and a case where data is stored temporarily. For example, the 'non-transitory storage medium' may include a buffer in which data is temporarily stored.

According to an embodiment, methods according to various embodiments disclosed herein may be included in a computer program product and then provided. The computer program product may be traded as a commodity between sellers and buyers. The computer program product may be distributed in the form of a machine-readable storage medium (e.g., a CD-ROM), or may be distributed online (e.g., downloaded or uploaded) through an application store or directly between two user devices (e.g., smart phones). In a case of online distribution, at least a portion of the computer program product (e.g., a downloadable app) may be temporarily stored in a machine-readable storage medium such as a manufacturer's server, an application store's server, or memory of a relay server.

## Claims

1. An induction heating device (2000) comprising:
a heating coil board (10) formed by stacking a plurality of heating coil pattern layers on which heating coils are printed and patterned;
an intermediate board (20) arranged under the heating coil board and comprising resonant capacitors that resonate with the heating coils such that a magnetic field is generated in the heating coils; and
an inverter board (30) comprising a switching inverter configured to generate the resonance,
wherein the intermediate board further comprises a first connector (110), the inverter board further comprises a second connector (120), and
an electrical connection between the intermediate board and the inverter board is established based on the first connector (110) and the second connector (120) being connected to each other in a vertical direction.

2. The induction heating device of claim 1, wherein the heating coil board comprises a third connector for electrical connection to the intermediate board,
the intermediate board comprises a fourth connector for connection to the third connector in a vertical direction, and
an electrical connection between the heating coil board and the intermediate board is established solely by connection between the third connector and the fourth connector.

3. The induction heating device of claim 1 or 2, wherein the patterned heating coils included in the heating coil board resonate with the resonant capacitors of the intermediate board via the third connector.

4. The induction heating device of claim 2, wherein the third connector is vertically mounted on a lower surface of the heating coil board, and
the fourth connector is vertically mounted on a lower surface of the intermediate board.

5. The induction heating device of claim 2, wherein the third connector is mounted on a lower surface of the heating coil board, and
the fourth connector is mounted on an upper surface of the intermediate board.

6. The induction heating device of any one of claims 1 to 5, wherein the third connector is a male connector mounted on the lower surface of the heating coil board, and
the fourth connector is a female connector.

7. The induction heating device of any one of claims 1 to 5, wherein the third connector is a female connector mounted on the lower surface of the heating coil board, and
the fourth connector is a male connector.

8. The induction heating device of any one of claims 1 to 7, wherein the first connector is a male connector mounted on the lower surface of the intermediate board, and
the second connector is a female connector mounted on the inverter board.

9. The induction heating device of any one of claims 1 to 7, wherein the first connector is a female connector mounted on the lower surface of the intermediate board, and
the second connector is a male connector mounted on the inverter board.

10. The induction heating device of any one of claims 1 to 9, wherein all electrical connections between the intermediate board and the inverter board are established solely by connection between the first connector and the second connector.

11. The induction heating device of any one of claims 1 to 10, wherein the plurality of heating coil pattern layers are formed by stacking six or more pattern layers including an insulating layer, and
the insulating layer is inserted between the heating coil pattern layers on which the heating coils are printed among the plurality of heating coil pattern layers.

12. An induction heating device comprising:
a heating coil board formed by stacking a plurality of heating coil pattern layers on which heating coils are printed and patterned, wherein the heating coil board comprises at least one heating coil board connector;
and
an inverter board comprising resonant capacitors that resonate with the heating coils, at least one first inverter board connector that is connected to the at least one heating coil board connector in a vertical direction, and an inverter that generates resonance between the heating coils and the resonant capacitors,
wherein an electrical connection between the heating coil board and the inverter board is established solely by connection between the at least one heating coil board connector and the at least one first inverter board connector.

13. The induction heating device of claim 12, further comprising an intermediate board arranged between the heating coil board and the inverter board, and comprising memory storing a program that controls an operation of the induction heating device and a processor configured to execute the program stored in the memory to control the induction heating device,
wherein the intermediate board comprises a hole through which the at least one heating coil board connector passes.

14. The induction heating device of claim 13, wherein the intermediate board comprises at least one intermediate board connector for electrical connection to the inverter board,
the inverter board further comprises at least one second inverter board connector that is connected to the intermediate board connector in a vertical direction, and
an electrical connection between the intermediate board and the inverter board is established solely by connection between the at least one intermediate board connector and the at least one second inverter board connector.

15. The induction heating device of claim 12, wherein the inverter board further comprises memory storing a program for controlling an operation of the induction heating device, a processor configured to execute the stored program to control the induction heating device, and a power converter configured to supply power to the processor and the memory.
